# EUROPEAN PATENT APPLICATION

(11) **EP 1 569 349 A1**
(43) Date of publication of application: **31.08.2005**
(21) Application number: 04290488.8
(22) Date of filing: 23.02.2004
(51) Int. Cl.: H03M 13/27, H03M 13/29

(54) **Alternative concatenated coding scheme for digital signals**

(71) Applicant: ALCATEL, 75008 Paris (FR)
(72) Inventor: Gastaldello, Stefano, 35037 Teolo Padova (IT); Razzetti, Luca, 20099 Sesto San Giovanni Milano (IT); Cucchi, Silvio, 20083 Gaggiano Milano (IT); Andreasi, Marco, 20093 Cologno Monzese Milano (IT)
(74) Representative: Menzietti, Domenico

(57) **Abstract**

A method is described to perform a concatenated coding of digital signals arranged in frames, in order to have a frame functionally compliant to ITU-T G.709 but with a coding gain better than the complete standardized frame and without increasing the line bit rate. This is achieved using in the transmission side an alternative concatenated coding scheme including an interleaving and a subsequent deinterleaving step and two particular Reed-Solomon codes.

## Description

The present invention relates to the telecommunication field and more in particular to a concatenated coding scheme for digital signals transmitted in frames. Still more in particular the invention concerns two concatenated Reed-Solomon codes and an interleaving/deinterleaving method in order to have a frame functionally compliant to ITU-T G.709/Y.1331 (3/2003).

Coding schemes are used to improve performance of a transmission channel, in order to reduce the bit error rate at a given value of signal to noise ratio, or to have the same bit error rate but at a lower value of the signal to noise ratio. This is achieved at the transmitter side by an encoder which adds some additional bits called redundant bits derived from information bits to those information bits and this introduces an increase of line bit rate. At the receiver side a decoder detects the additional bits which are used to correct erroneous information bits. Two main types of coding schemes are block codes and convolutional codes. A third type, defined as concatenated code, is obtained with a combination of two or more block and/or convolutional codes. Reed-Solomon (RS) code is a well known block code. In binary codes each symbol carries one bit, while in non binary codes each symbol carries m bits, with m>1. RS is a non binary code where m=8, so each symbol represents a byte. A data bit stream is divided in blocks of bytes with length K; redundant bytes (also referred as parity bytes) are added so that codeword length is N (N-K are redundant bytes). The coding ratio is defined as K/N and, multiplied by 100, is an indication of the percentage of information bytes in the code word. The quality of a code is expressed in terms of net coding gain (NCG), defined as the difference between Signal to Noise Ratio (SNR) required without data encoding and SNR required with error correction in order to have a predetermined Bit Error Rate (BER), usually 10*^ (-13). RS is a systematic code: this means that parity bytes are appended after information bytes. It is known in the art that a RS code can detect up to (N-K) erroneous bytes in a block and can locate and correct until (N-K)/2 errored bytes in a block. For example a RS(255,239) is a Reed-Solomon code with N=255 and K=239, which can correct up to 8 erroneous bytes in a single codeword of length 255. The coding ratio is 239/255 = 0.93: this means that about 7% of the code words are used for parity bytes and 93% are information bytes. One advantage of RS codes is the low complexity of both the encoder and decoder.

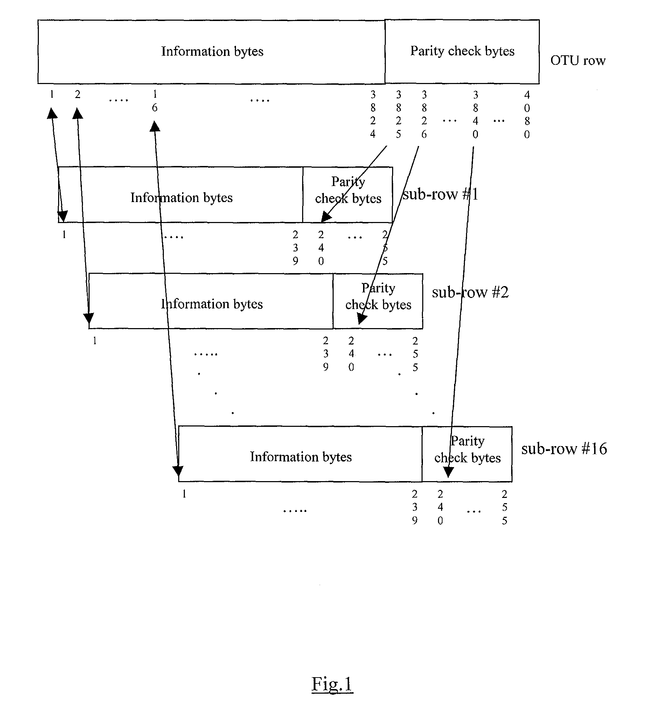

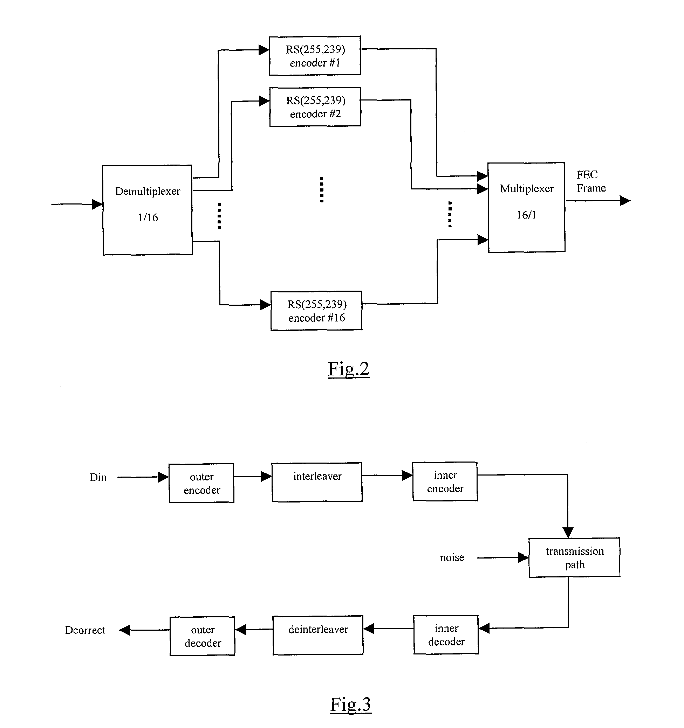

Performance of a block code can be improved with a process called "byte-interleaving", shown in Fig.1. A RS code using byte-interleaving is proposed for the optical channel in ITU-T G.975 (10/2000) for submarine optical transmission systems and in ITU-T G.709/Y.1331 (3/2003) Annex A for terrestrial optical transmission systems, where a forward error correction (FEC) code using a 16-byte interleaved RS(255,239) is proposed. According to ITU-T G.709, an Optical channel Transport Unit (OTU) frame is composed of 4 rows and each row is composed of 4080 bytes. Bytes from 1 to 3824 are information bytes and from 3825 to 4080 are parity checks bytes of the RS(255,239) code. Each row is divided in 16 sub-rows using 16 byte-interleaving, as shown in Fig.1. The FEC parity check bytes are calculated over the information bytes 1 to 239 of each sub-row and transmitted in bytes 240 to 255 of the same sub-row. FEC encoder architecture is shown in Fig.2: each of the 16 encoders processes a sub-row adding parity bytes and then codewords are multiplexed into a serial data. In this way burst errors at the receiver are located in different decoders and so each decoder can correct them. This frame structure is defined in ITU-T G.709 as completely standardized and is indicated with OTUk: each row has information bytes from position 1 to 3824 and redundancy bytes of RS(255,239) code from position 3825 to 4080. To support alternative FEC, ITU-T G.709 also provides a frame structure that is only functionally standardized, that is only the required functionality is specified: this is referred as OTUkV frame structure. In this frame structure each row has information bytes from position 1 to 3824, while bytes from position 3825 to 4080 are available for FEC redundancy, to allow coding schemes different from the RS(255,239).

According to the completely standardized solution, this coding achieves a net coding gain of 5.8 dB with 7% redundancy, so performance is improved but is not enough for some applications where a high span length is required between two equipments, two optical repeaters or between an equipment and an optical repeater. A possible solution would be to use a better code, with more additional parity bytes to correct more erroneous bytes, but this requires a higher bit rate and a more complex decoder. In fact the quality of high-rate electronics and optics components used by transmitter and receiver drastically decreases when bit rate increases: for this reason FEC schemes having less than 20 % of code overhead should be considered. Moreover the frame would not be compliant to bit rate defined in ITU-T G.709. Increase of line bit rate is also a disadvantage for the reason that the same board can't be used with different coding schemes having different bit rates. Several components are mounted on a board, like a microprocessor, ASICs, oscillators, optical components. Some of them can work only at some bit rates or in small range around these bit rates: for example an ASIC like a serdes (serializer/deserializer) can work only at a fixed value of bit rate. For these reasons a different bit rate requires different hardware components and this is an increase of the cost.

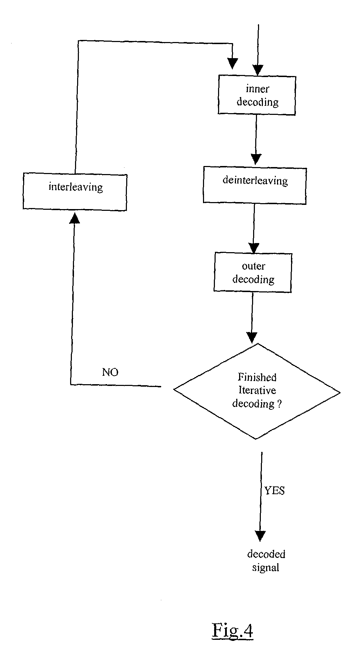

One solution is to use a concatenated coding scheme which can achieve the same performance as that of a single and powerful error correcting code but with a lower decoding complexity, without increasing or with a small increase of the line bit rate respect to a single coding scheme. Referring to Fig. 3, one solution is to concatenate two codes, an outer code and an inner code, with an "interleaving" process between them (in the figure is indicated the interleaver, that is the hardware mean used to perform the interleaving process). Interleaving process consists in a change of the order of bits/bytes (in this scheme before the inner coding process) for the same reason explained for byte-interleaving, that is to improve the immunity of the optical fibre cable system to burst errors: in this way burst errors at the receiver are located in different blocks of the inner decoder and so the decoder can correct them. The inverse process is called deinterleaving and restores the order of bit/bytes. In an embodiment of a concatenated coding at the receiver side the inner code is used to operate at higher BER and the outer code at a low BER, so that outer decoder corrects only remaining errors not corrected by inner decoder. The inner code can be a convolutional one which operates better at higher BER while the outer code can be a block one which operates better at low BER. Alternatevely they can both be block codes, with the inner code with a code ratio higher than the outer code. Performance of concatenated codes can also be improved by using an iterative decoding: this technique offers the advantage of improving FEC efficiency without increasing line bit rate. Referring to Fig.4, the first iteration, implemented by the previous decoding stage of Fig.3, includes the steps of inner decoding, deinterleaving and outer decoding, which provides the decoded data. For the second iteration decoded data is interleaved again and fed to the inner decoding and the process can be iterated. Usually 2 stages iterative decoding scheme is performed, because decoder complexity is greater with increasing of the number of the iterations.

Many concatenated coding schemes solutions have been proposed to improve performance respect to the completely standardized frame defined in ITU-T G.709, with a different net coding gain, depending on the type of codes and of interleaving. These schemes are not compliant to the functionally standardized frame because require a higher line bit rate and different frame structures.

In summary, by implementing coding schemes, the following problems arise:
- concatenated coding schemes are usually not compliant to the functionally standardized frame defined in ITU-T G.709, because of a different line bit rate and a different frame structure;
- a concatenated coding scheme requires the choice of an outer and of an inner code able to locate and correct erroneous bytes minimizing line bit rate;
- a concatenated coding scheme requires the choice of a good interleaving to divide errors in different blocks.

In view of the drawbacks and deficiencies of the known and standardized solutions, as described above, the main object of the present invention is to provide an alternative concatenated coding scheme in order to have an encoded signal transmitted in frames compliant to the functionally standardized frame defined in ITU-T G.709/Y.1331 (3/2003), increasing coding gain respect to the completely standardized frame and keeping the line bit rate constant. This object is achieved by a method according to claim 1 and by a method according to claim 2.

In summary, by implementing the alternative concatenated coding scheme, it is possible:
- to be compliant to the functionally standardized frame defined in ITU-T G.709/Y.1331 (3/2003);
- to increase coding gain keeping the line bit rate constant;
- to increase transmission length or to decrease the cost of the system;
- to allow to use the same board with different coding schemes having the same bit rate, decreasing the cost of a network element.

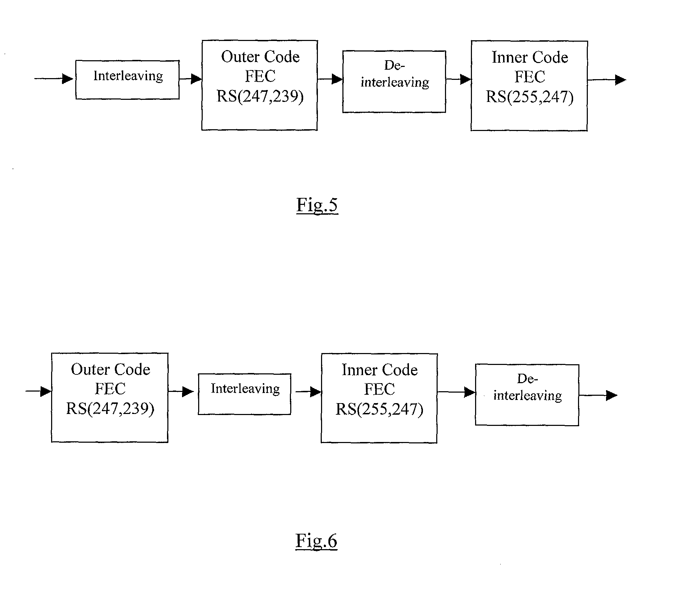

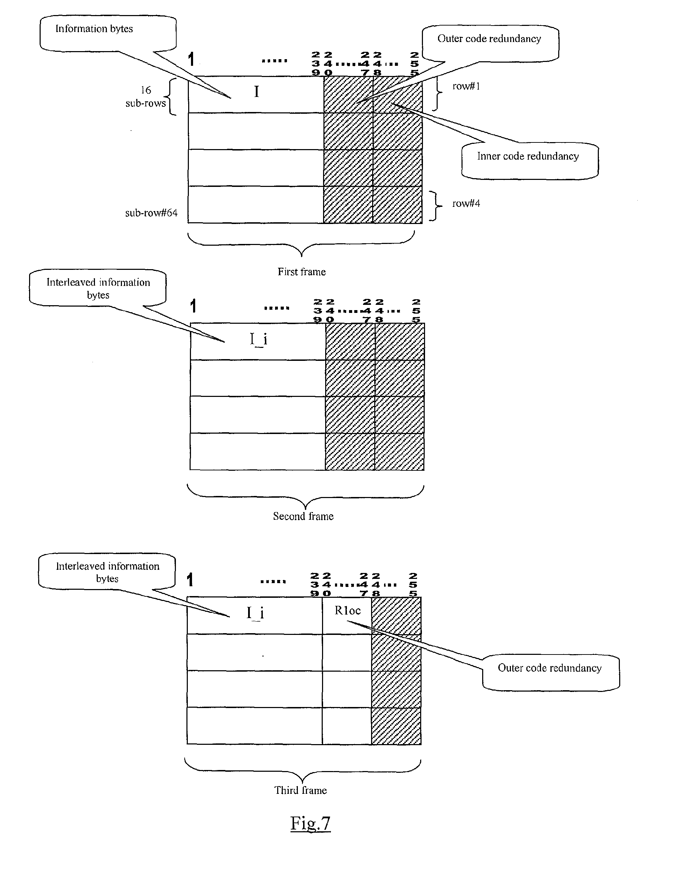

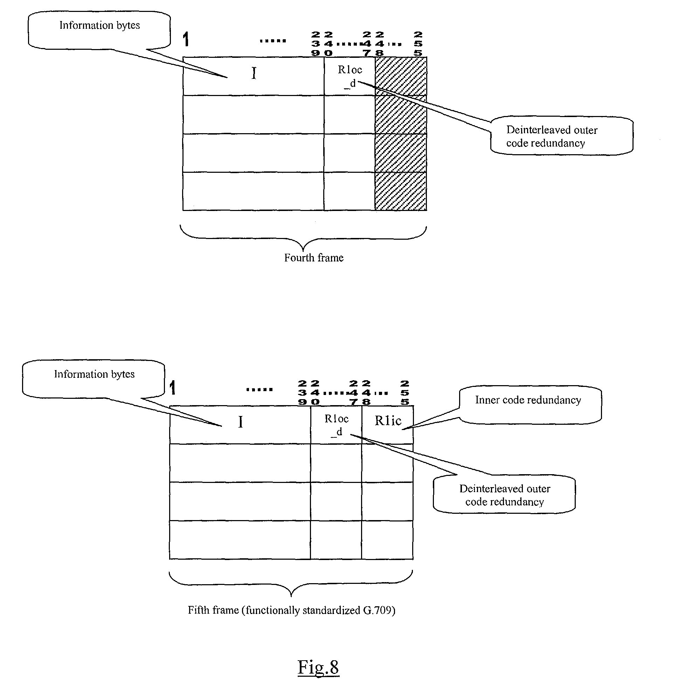

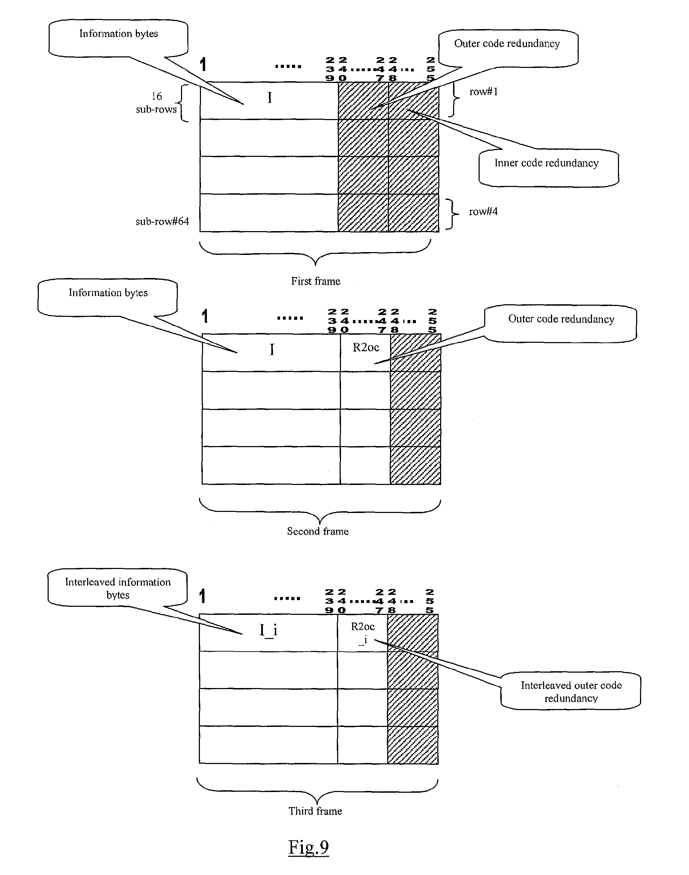

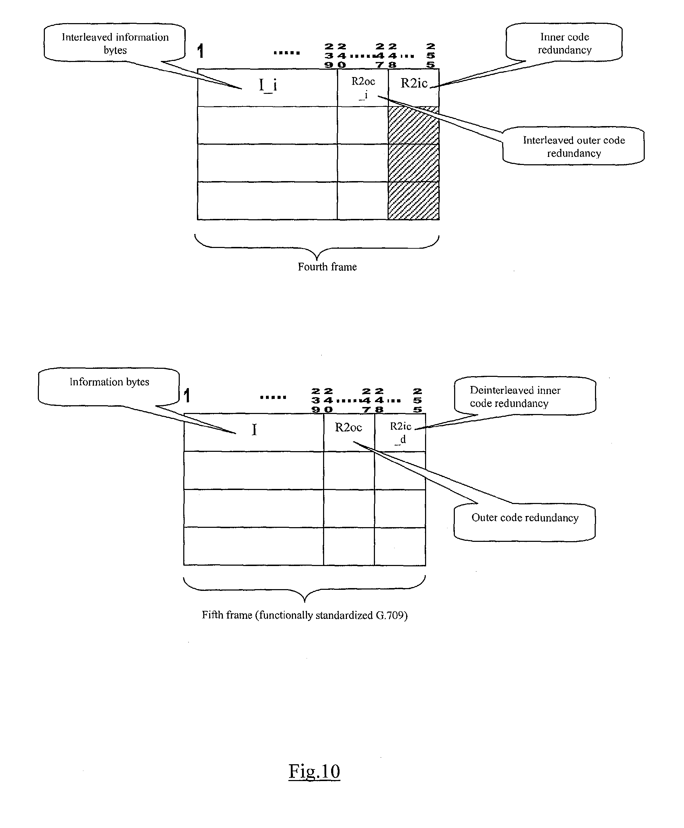

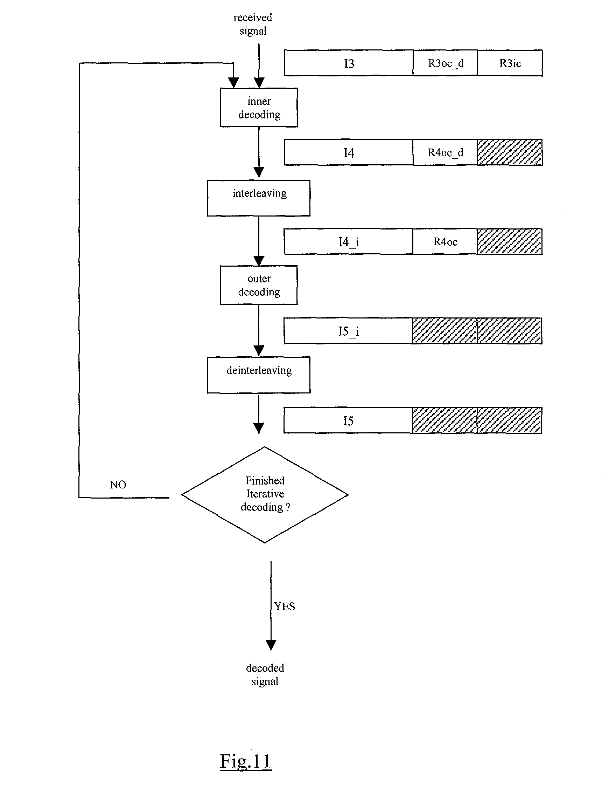

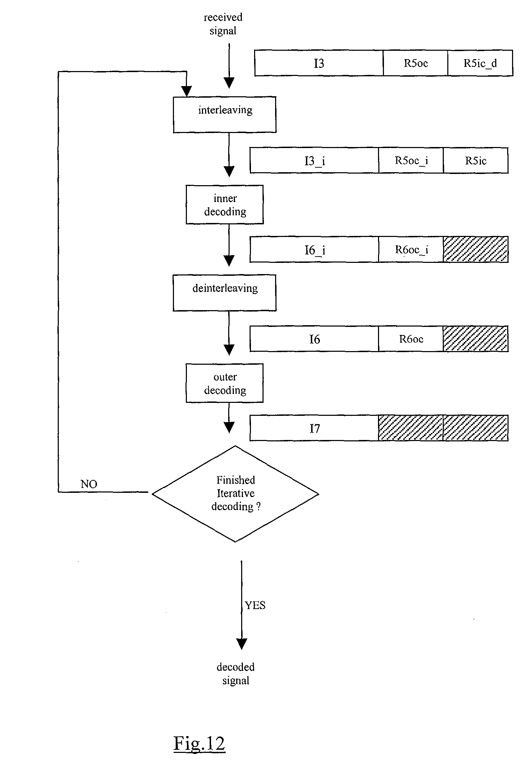

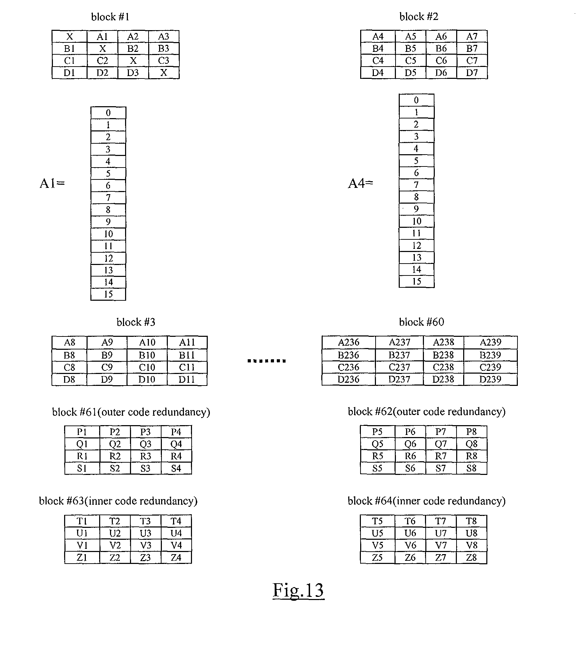

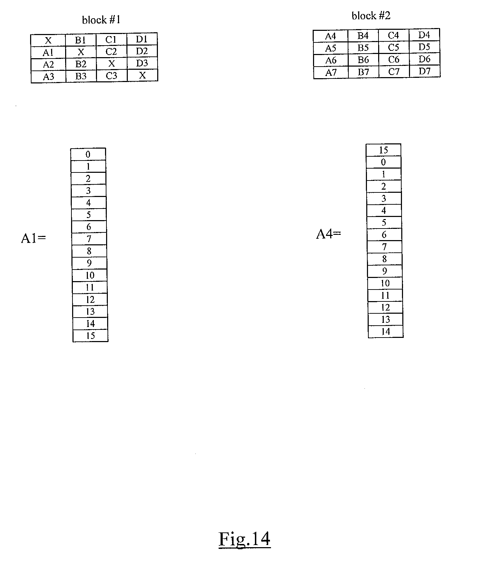

The invention will become fully clear from the following detailed description, given by way of a mere exemplifying and non limiting example, to be read with reference to the attached drawing figures. Fig.1, 2, 3 and 4 relates to the prior art. Fig.1 shows one OTU row divided in 16 sub-rows for FEC processing. Fig.2 shows a FEC encoder architecture. Fig.3 shows a concatenated coding scheme. Fig.4 shows an iterative decoding scheme. Fig.5 shows a first preferred embodiment of the inventive concatenated coding scheme at the transmission side. Fig.6 shows a second preferred embodiment of the inventive concatenated coding scheme at the transmission side. Fig.7 and 8 show frames related to the scheme of Fig.5. Fig.9 and 10 show frames related to the scheme of Fig.6. Fig.11 shows the iterative decoding process in the receiving side of the scheme of Fig.5. Fig.12 shows the iterative decoding process in the receiving side of the scheme of Fig.6. Fig.13 and Fig.14 show the interleaving process of the schemes of Fig.5, 6, 11 and 12.

Some considerations are common to the two preferred embodiments of Fig.5 and Fig.6, wherein the inventive method is used in a concatenated coding scheme for digital signals arranged in frames and wherein the input of the coding scheme is compliant to ITU-T G.709. The interleaving and deinterleaving processes are applied on the complete frame while the outer code and the inner code are applied on each sub-row: this can be performed with 16 outer code processes and 16 inner code processes, but alternatevely with only one outer code process and one inner code process using a time division elaboration. Both are block codes: the outer is a RS(247,239) and the inner is a RS(255,247), so the 16 bytes available for FEC redundancy are equally divided for the two codes. The encoded signal at the output of the coding scheme, that is the output of the inner code, is compliant to the functionally standardized frame defined in ITU-T G.709. This is achieved, as will be explained later, with the interleaving and the following deinterleaving process in order to restore the initial position of bytes in the information part of the frame. It is also required that interleaving and deinterleaving processes are designed to change order of bytes separately for information part, redundancy part of the outer code and redundancy part of the inner code. This means that position of bytes are changed only inside each part:
- from one position of the information part to a different position of the information part;
- from one position of the redundancy part of the outer code to a different position the redundancy part of the outer code;
- from one position of the redundancy part of the inner code to a different position the redundancy part of the inner code.

It is not possible, for example, to change position of bytes according to a rule from the information part to the redundancy part of the outer code part, because in the functionally standardized frame information bytes can't occupy the positions available for the FEC redundancy bytes (and viceversa).

Referring to Fig.5, the first embodiment is a concatenated coding scheme composed of a series connection of an interleaving, an outer code, a deinterleaving and an inner code. Referring to Fig.7 and 8, the first frame is the input of the coding scheme and is functionally compliant to ITU-T G.709: it is composed of 4 rows, each row divided in 16 sub-rows of 255 bytes (with the process shown in Fig.1): columns from 1 to 239 are information bytes, from 240 until 247 are redundancy bytes of the outer code and from 248 until 255 are redundancy bytes of the inner code. The second frame is the output of the interleaving process, which changes the order of bytes of the first frame according to a rule. An interleaving including the features explained above is shown in Fig.13. The first frame is divided in 64 blocks: the information part from block #1 until block #60, the redundancy part of the outer code in block #61 and #62 and the redundancy part of the inner code in block #63 and #64. Each block is composed of words arranged in 4 rows and 4 colums, each word composed of 16 bytes arranged in a colum, each byte composed of 8 bits arranged in a row. The 4 rows of each block in Fig.13 corresponds to each of the 4 rows of the first frame of Fig.7, word A1 of Fig.13 corresponds to the first column of row #1 of the first frame of Fig.7. The information part of the first frame is composed of 239 columns but 60 blocks for the information part require 240 columns (60 blocks x 4 columns for each block = 240 columns), so in block #1 of information part is added one dummy word for each row and this word is indicated with an X. These dummy words are discarded when the result of interlaving is written in the second frame. The interleaving is applied separately for each block of the frame, in order to have the feature explained above, required to have a functionally standardized frame; referring to block #1 of Fig.13 and 14, the rule is to read words of the first column of the first frame and write in the first row of the second frame and repeating this read-write process for the second, third and fourth column of the block. The same rule is applied to all the blocks of the frame in order to have the second frame. In the first and second frame of Fig.7 the blocks related to the redundancy of the outer and of the inner code have background with light upward diagonal to indicate that these fields are not valid. The second frame includes changed information bytes according to the interleaving process, also referred as interleaved information bytes. The third frame is the output of the outer code: redundancy bytes of the outer code are calculated from interleaved information bytes and are placed in columns 240 until 247 of each sub-row. The fourth frame is the output of the deinterleaving process: words of the first row of each block of the third frame are read and written in the first column of each block of the fourth frame and this read-write process is repeated for the second, third and fourth row of each block. The result is the fourth frame wherein information bytes are restored to the positions of the first frame and the positions of the redundancy part of the outer code are changed according to the deinterleaving process. Restoring of information bytes to initial position is possible for the feature described for the interleaving and deinterleaving, that is not to change position of bytes between information part and redundancy part. Finally the fifth frame is the output of the inner code: redundancy bytes of the inner code are calculated from information bytes and deinterleaved redundancy bytes of the outer code and are placed from columns 248 until 255 of each sub-row. The fifth frame is the encoded signal and is composed of the information bytes, the deinterleaved redundancy of the outer code and the redundancy of the inner code. From the fifth frame can be understood that it is not necessary to apply the deinterleaving process on the information part but only on blocks of the redundancy part of the outer code. In fact in order to have all fields of the fifth frame (information bytes, deinterleaved redundancy of the outer code and redundancy of the inner code), the minimum steps required are: interleaving of the information bytes in order to have interleaved information bytes, calculation of redundancy bytes of the outer code from the interleaved information bytes, deinterleaving of the redundancy bytes of the outer code in order to have deinterleaved redundancy bytes of the outer code, calculation of redundancy bytes of the inner code from the information bytes and the deinterleaved redundancy bytes of the outer code.

Referring to Fig.6, the second embodiment is a concatenated coding scheme for digital signals arranged in frames and is composed of a series connection of an outer code, an interleaving, an inner code and a deinterleaving. Referring to Fig.9 and 10, a man skilled in the art can deduce that the first frame includes information bytes, the second frame information bytes and redundancy bytes of the outer code, the third frame the interleaved information bytes and the interleaved redundancy bytes of the outer code bytes, the fourth frame the interleaved information bytes, the interleaved redundancy bytes of the outer code and the redundancy bytes of the inner code and the fifth frame the informaton bytes, the redundancy bytes of the outer code and the deinterleaved redundancy bytes of the inner code. In this second embodiment the interleaving process required to have the third frame from the second one is again applied separately for the information part and the redundancy part of the outer code. The deinterleaving process can be applied only to the redundancy bytes of the inner code and not to the interleaved information bytes and interleaved redundancy bytes of the outer code, so the minimun steps required are: calculation of redundancy bytes of the outer code from information bytes, interleaving of the information bytes and redundancy bytes of the outer code in order to have interleaved information bytes and interleaved redundancy bytes of the outer code, calculation of redundancy bytes of the inner code from interleaved information bytes and interleaved redundancy bytes of the outer code, deinterleaving of redundancy bytes of the inner code in order to have deinterleaved redundancy bytes of the inner code.

The interleaving process can be improved with a second step. Referring to Fig.14, positions of bytes in the words of each block are changed according to a cyclic rotation from block to block: in the first block bytes of each word are unchanged like shown in word A1, in the second block bytes of each word are rotated by one like shown in word A4, in the third block bytes of each word are rotated by two and this rotation is repeated until block #16 where words are rotated by 15 bytes. Now the process is iterated in the same way from block #17, where words are unchanged, until the last block.

Fig.11 shows the receiving side related to the transmitting side of Fig.5, wherein only one row of the frame of each step is shown: it is an iterative decoding scheme where erroneous bytes can be corrected by the inner and by the outer decoding. The first iteration is composed of the following steps: inner decoding, interleaving, outer decoding and deinterleaving. The input of the decoding scheme is data received from transmission channel, which can include erroneous bytes for the additional noise on the channel, while the output is the decoded data, that is data where erroneous bytes are corrected by the inner and/or outer code. This flow can be iterated, to achieve a further coding gain. The input of the inner decoding is the signal received from the transmission channel and includes (see Fig.11) information bytes, deinterleaved outer code redundancy bytes and inner code redundancy bytes. Inner code redundancy bytes are used by the inner decoding to correct erroneous information bytes and erroneous deinterleaved outer code redundancy bytes; these inner code redundancy bytes are stored because are required for subsequent iterations. The output of the inner decoding is a signal including information bytes and deinterleaved outer code redundancy bytes. This signal is the input of the interleaving, which changes order of information bytes and deinterleaved outer code redundancy bytes in order to have a signal including interleaved information bytes and outer code redundancy bytes. Outer code redundancy bytes are used by the outer decoding to correct erroneous interleaved information bytes; these outer code redundancy bytes are stored because are required for subsequent iterations. The output of the outer decoding is a signal including interleaved information bytes. Finally this signal is the input of the deinterleaving, which changes order of interleaved information bytes in order to have a signal including information bytes. This is the decoded signal after the first iteration; a second iteration can be performed to correct further erroneous bytes, repeating inner decoding, interleaving, outer decoding and deinterleaving.

Fig.12 shows the receiving side related to the transmitting side of Fig.6: the first iteration is composed of the following steps: interleaving, inner decoding, deinterleaving and outer decoding. The input of the interleaving is the signal received from the transmission channel and includes information bytes, outer code redundancy bytes and deinterleaved inner code redundancy bytes. It is understood from the previous explanation that the output of the interleaving is a signal including interleaved information bytes, interleaved outer code redundancy bytes and inner code redundancy bytes, the output of the inner decoding is a signal including interleaved information bytes and interleaved outer code redundancy bytes, the output of the deinterleaving is a signal including information bytes and outer code redundancy bytes and the output of the outer decoding is a signal including information bytes.

The difference between the two embodiments can be understood from the receiving side wherein the two decoding processes are used for a different purpose. Data received from the channel can include two types of errors: burst errors and random errors. The two RS codes can correct until 4 erroneous bytes for each block. The purpose of the interleaving/deinterleaving process is to divide burst errors, which can be in a block a number greater than 4, in different blocks, so that each block has a number of erroneous bytes smaller than 4 and they can be corrected. In Fig.11 input of inner decoding is data received from the channel, which can include burst errors and random errors. The inner decoding can correct in a block random errors but a number of burst errors greater than 4 are not corrected. The signal is interleaved and so burst errors of one block are split in random errors of different blocks. This signal is the input of the outer decoding which can correct now these random errors. In the decoding process of Fig.12 data received from the channel, which can include burst errors and random errors, is interleaved in order to have only random errors; the interleaved signal is the input of inner decoding which can correct these random errors. The input of the outer decoding is a signal which can still include random errors that can be corrected by the outer decoding. In summary, in the decoding process of Fig.11 the inner decoding can correct random errors and the outer decoding the errors that were burst errors in the received signal, while in Fig.12 the inner decoding can correct the errors that were burst errors in the received signal and also the random errors and the outer decoding the remaining errors.

According to the first preferred embodiment (with 2 steps interleaving/deinterleaving), it is possible to achieve a coding gain of about 7.25 dB with 2 steps iterative decoding, compared with the net coding gain of 5.8 dB of a single RS(255,239) code proposed in ITU-T G.709/Y.1331 (3/2003).

This concatenated coding scheme can be advantageously implemented on a network element, for example an Add-Drop Multiplexer (ADM), including hardware devices like an Application Specific Integrated Circuit (ASIC), Field Programmable Gate Array (FPGA), microprocessor or memories to perform concatenated coding; these devices include for example a transmitter and a receiver. In the first preferred embodiment the transmitter is a series connection of an interleaver to perform interleaving, an outer encoder to calculate outer code redundancy, a deinterleaver to perform deinterleaving and an inner encoder to calculate inner code redundancy; the receiver is a series connection of an inner decoder, an interleaver, an outer decoder and a deinterleaver. In the second preferred embodiment the transmitter is a series connection of an outer encoder to calculate outer code redundancy, an interleaver to perform interleaving, an inner encoder to calculate inner code redundancy and a deinterleaver to perform deinterleaving; the receiver is a series connection of an interleaver, an inner decoder, a deinterleaver and an outer decoder. Interleaver (and deinterleaver) is for example implemented using combinational and sequential logic; this logic controls read and write operations to access memories, usually Random Access Memories (RAM), which are required to store the frames.

The method is implemented in a preferred embodiment through or together with a software program like Very high speed integrated circuit Hardware Description Language (VHDL) or C language, by one or more VHDL processes or C routines. The network element thus includes for example for encoding digital signals to be transmitted a first software process for outer encoding, a second software process for interleaving and deinterleaving and a third software process for inner encoding; for decoding received digital signals a fourth software process for inner decoding, a fifth software process for deinterleaving and interleaving and a sixth software process for outer decoding.

## Claims

1. Method for encoding a digital signal including information bits (I) into an encoded signal, the method including the following steps:
a) changing the order of the information bits (I) to changed information bits (I_i) according to a first rule (interleaving);
b) calculating outer code redundancy bits (R1oc) from the changed information bits (I_i);
c) changing the order of the outer code redundancy bits (R1oc) to changed outer code redundancy bits (R1oc_d) according to a second rule (deinterleaving), wherein the second rule is inverse to the first rule;
d) calculating inner code redundancy bits (R1ic) from the information bits (I) and the changed outer code redundancy bits (R1oc_d);
e) providing the encoded signal including the information bits (I), the changed outer code redundancy bits (R1oc_d) and the inner code redundancy bits (R1 ic).

2. Method for encoding a digital signal including information bits (I) into an encoded signal, the method including the following steps:
a) calculating outer code redundancy bits (R2oc) from the information bits (I);
b) changing the order of the information bits (I) to changed information bits (I_i) and of the outer code redundancy bits (R2oc) to changed outer code redundancy bits (R2oc_i) according to a first rule (interleaving);
c) calculating inner code redundancy bits (R2ic) from the changed information bits (I_i) and the changed outer code redundancy bits (R2oc_i);
d) changing the order of the inner code redundancy bits (R2ic) to changed inner code redundancy bits (R2ic_d) according to a second rule (deinterleaving), wherein the second rule is inverse to the first rule;
e) providing the encoded signal including the information bits (I), the outer code redundancy bits (R2oc) and the changed inner code redundancy bits (R2ic_d).

3. Frame for transmitting a digital signal being encoded according to claim 1 or 2, the frame including:
- information bits;
- outer code redundancy bits; and
- inner code redundancy bits;
wherein either the inner or the outer code redundancy bits are changed inner (R2ic_d) or changed outer (R1oc_d) code redundancy bits according to the second rule, respectively.

4. Method according to claim 1, wherein the step c) also includes changing of the order of the changed information bits (I_i) to the information bits (I) according to the second rule (deinterleaving).

5. Method according to claim 2, wherein the step d) also includes changing of the order of the changed information bits (I_i) to the information bits (I) and of the changed outer code redundancy bits (R2oc_i) to the outer code redundancy bits (R2oc) according to the second rule (deinterleaving).

6. Method according to claims 1 or 2, **characterized in that** the outer code is a RS(247,239) and the inner code is a RS(255,247).

7. Method for decoding a signal encoded according to claim 1 and received from a transmission channel into a decoded signal, including the following steps:
- an inner decoding of the received signal including information bits (13), changed outer code redundancy bits (R3oc_d) and inner code redundancy bits (R3ic) to a signal including further information bits (14) and further changed outer code redundancy bits (R4oc_d);
- changing the order of the information bits (14) to further changed information bits (14_i) and the order of the changed outer code redundancy bits (R4oc_d) to further outer code redundancy bits (R4oc) according to the first rule (interleaving) ;
- an outer decoding of the signal including the changed information bits (14_i) and the outer code redundancy bits (R4oc) to a signal including further changed information bits (15_i);
- changing the order of the changed information bits (15_i) to further information bits (15) according to the second rule (deinterleaving);
- iterating the inner decoding, the changing of the order of bits according to the first rule, the outer decoding and the changing of the order of bits according to second rule at least one time;
- providing the decoded signal from the last changing of the order of bits according to the second rule (deinterleaving).

8. Method for decoding a signal encoded according to claim 2 and received from a transmission channel into a decoded signal, including the following steps:
- changing the order of the information bits (13) of the received signal to further changed information bits (13_i), the order of outer code redundancy bits (R5oc) of the received signal to further changed outer code redundancy bits (R5oc_i) and the order of changed inner code redundancy bits (R5ic_d) of the received signal to further inner code redundancy bits (R5ic) according to the first rule (interleaving) ;
- an inner decoding of the signal including the changed information bits (13_i), the changed outer code redundancy bits (R5oc_i) and the inner code redundancy bits (R5ic) to a signal including further changed information bits (16_i) and further changed outer code redundancy bits (R6oc_i);
- changing the order of the changed information bits (16_i) to further information bits (16) and the order of the changed outer code redundancy bits (R6oc_i) to further outer code redundancy bits (R6oc) according to the second rule (deinterleaving);
- an outer decoding of the signal including the information bits (16) and the outer code redundancy bits (R6oc) to a signal including further information bits (17);
- iterating the changing of the order of bits according to the first rule, the inner decoding, the changing of the order of bits according to the second rule and the outer decoding at least one time;
- providing the decoded signal from the last outer decoding step.

9. Software program comprising software program code means adapted to perform all the steps of the method according to claim 1 and 7 when the program is run on a hardware, the program including for encoding digital signals to be transmitted:
- a first process for outer encoding;
- a second process for changing the order of bits according to the first and/or to the second rule;
- a third process for inner encoding;
and for decoding received digital signals:
- a fourth process for inner decoding;
- a fifth process for changing the order of bits according to the first or to the second rule;
- a sixth process for outer decoding.

10. Software program comprising software program code means adapted to perform all the steps of the method according to claim 2 and 8 when the program is run on a hardware, the program including for encoding digital signals to be transmitted:
- a first process for outer encoding;
- a second process for changing the order of bits according to the first and/or to the second rule;
- a third process for inner encoding; and for decoding received digital signals:
- a fourth process for inner decoding;
- a fifth process for changing the order of bits according to the first or to the second rule;
- a sixth process for outer decoding.

11. Device to perform all the steps of the method according to claims 1 and 7 and including a transmitter and a receiver, the transmitter including a series connection of:
- an interleaver to change the order of bits according to the first rule;
- an outer encoder to calculate the outer code redundancy bits;
- a deinterleaver to change the order of bits according to the second rule;
- an inner encoder to calculate the inner code redundancy bits;
and the receiver including a series connection of:
- an inner decoder to decode the received signal;
- an interleaver to change the order of bits according to the first rule;
- an outer decoder to decode the signal including the changed information bits and the outer code redundancy bits;
- a deinteleaver to change the order of bits according to the second rule.

12. Device to perform all the steps of the method according to claims 2 and 8 and including a transmitter and a receiver, the transmitter including a series connection of:
- an outer encoder to calculate the outer code redundancy bits;
- an interleaver to change the order of bits according to the first rule;
- an inner encoder to calculate the inner code redundancy bits;
- a deinterleaver to change the order of bits according to the second rule;
and the receiver including a series connection of:
- an interleaver to change the order of bits according to the first rule;
- an inner decoder to decode the signal including the changed information bits, the changed outer code redundancy bits and the inner code redundancy bits;
- a deinteleaver to change the order of bits according to the second rule.
- an outer decoder to decode the signal including the changed information bits and the outer code redundancy bits.
